# EUROPÄISCHE PATENTSCHRIFT

(11) **EP 0 905 897 B1**
(45) Veröffentlichungstag und Bekanntmachung des Hinweises auf die Patenterteilung: **15.01.2003**
(21) Anmeldenummer: 98116120.1
(22) Anmeldetag: 26.08.1998
(51) Int. Cl.: H03K 5/24, H03K 3/0233, H03K 3/3565

(54) **Komparatoranordnung mit Schalthysterese**
Comparator with Hysteresis
Comparateur avec Hystérésis

(30) Priorität: 26.09.1997 DE 19742576
(43) Veröffentlichungstag der Anmeldung: 31.03.1999
(73) Patentinhaber: Infineon Technologies AG, 81669 München (DE)
(72) Erfinder: Zitta, Heinz, 9580 Drobollach (AT)
(74) Vertreter: Patentanwälte Westphal, Mussgnug & Partner

(56) Entgegenhaltungen:
- US-A- 3 725 673
- US-A- 4 677 315
- US-A- 5 268 872
- US-A- 5 336 942
- US-A- 5 369 319
- "COMPARATOR WITH IMPROVED TEMPERATURE AND PROCESS COMPENSATED HYSTERESIS CHARACTERISTIC" RESEARCH DISCLOSURE,GB,INDUSTRIAL OPPORTUNITIES LTD. HAVANT, Nr. 382, Seite 146 XP000553650 ISSN: 0374-4353

## Beschreibung

Die Erfindung betrifft eine Komparatoranordnung mit Schalthysterese.

Mittels eines Komparators wird ein Eingangssignal mit einem Vergleichswert verglichen. Der Vergleichswert wird durch eine Schaltschwelle des Komparators gebildet. Wenn das Eingangssignal größer als der Vergleichswert ist, schaltet das binäre Ausgangssignal in einen ersten Zustand; wenn das Eingangssignal kleiner als der Vergleichswert ist, schaltet das Ausgangssignal in einen komplementären zweiten Zustand. Durch eine Schalthysterese wird erreicht, daß die Schaltschwellen und die Vergleichswerte abhängig vom bisherigen Schaltzustand des Komparators unterschiedlich sind. Bei Herstellung in integrierter Schaltungstechnik besteht das Problem der genauen Einstellung der Schaltschwellen und der Hysterese, da die absoluten Kenngrößen der Bauelemente relativ großen Schwankungen unterliegen.

In der US 5 166 550 ist eine Komparatorschaltung mit variabler Hysterese beschrieben. Einem Komparator wird ein Eingangssignal sowie ein Referenzsignal zugeführt. Die Hysterese wird dadurch bewirkt, daß dem Eingangssignal über Schaltmittel eine zusätzliche Spannung überlagert wird. Die zusätzliche Spannung wird abhängig von dem Referenzsignal gesteuert. Die Schaltmittel werden abhängig vom Ausgangssignal des Komparators gesteuert.

In der US 5 369 319 ist ein Komparator mit Hysterese gezeigt, der aus MOS-Transistoren gebildet ist. Ein Differenzverstärker des Komparators enthält einen Stromquellentransistor, der von einer Steuerschaltung angesteuert wird, um Temperatur- und Herstellungsschwankungen auszugleichen. Der Stromquellentransistor bildet mit der Steuerschaltung einen Stromspiegel. In der Steuerschaltung werden die Lastströme in den Komparatorzweigen an den jeweiligen Schaltpunkten des Komparators nachgebildet. Durch diese Schaltungsanordnung sollen Schwankungen auf die Hysterese durch einen Regelkreis ausgeregelt werden. Die Komparatoranordnung stellt hierzu eine weitestgehend variable Schalthysterese sowie Mittel zur Erzeugung eines einzigen Referenzsignals bereit.

Die Aufgabe der Erfindung besteht darin, eine Komparatoranordnung mit Schalthysterese anzugeben, deren kennzeichnende Parameter möglichst genau und möglichst unabhängig von Fertigungsstreuungen herstellbar sind.

Diese Aufgabe wird durch eine Komparatoranordnung nach den Merkmalen des Patentanspruchs 1 gelöst.

Bei der Komparatoranordnung gemäß der Erfindung werden eine der Schaltschwellen der Vergleichskomparatoren sowie die darauf bezogene Hysterese jeweils durch Referenzspannungen festgelegt. Eine Regelschaltung sorgt für die Kompensation von Fertigungsstreuungen und Temperatureinflüssen. Die Schaltschwellen sowie die Hysterese sind daher mit hoher Genauigkeit einstellbar. Zur Realisierung der Vergleichskomparatoren werden "unsymmetrische" Komparatoren mit schaltbarem Offset verwendet, die eine geringe Chipfläche bei integrierter Realisierung benötigen. Die Regelschaltung ist zur Ansteuerung von Komparatoren nur einmal erforderlich, so daß eine chipflächengünstige Gesamtanordnung erhalten wird.

Vorteilhafte Weiterbildungen der Erfindung sind in den abhängigen Ansprüchen angegeben.

Nachfolgend wird die Erfindung anhand des in der Zeichnung dargestellten Ausführungsbeispiels näher erläutert. Es zeigen:
- Figur 1: eine Realisierung der Komparatoranordnung in MOS-Schaltungstechnik und
- Figur 2: ein Signaldiagramm für einen Vergleichskomparator.

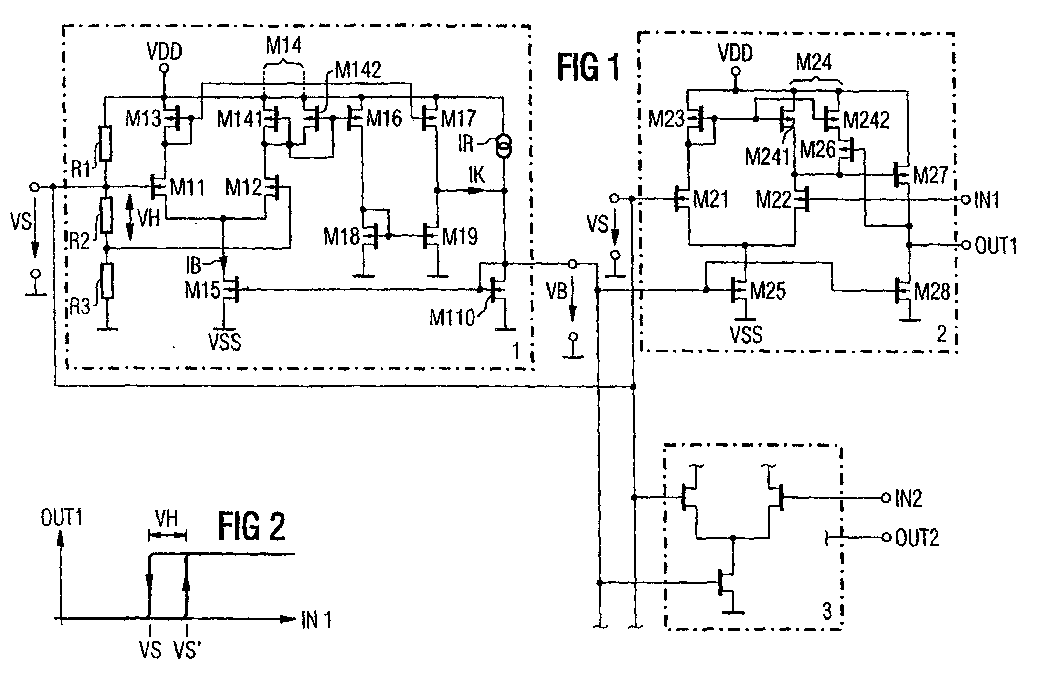

Dem in Figur 1 dargestellten Vergleichskomparator 2 wird ein Eingangssignal IN1 zugeführt, das mit je nach dem momentanen Schaltzustand unterschiedlichen Schaltschwellen verglichen wird, um das Ausgangssignal OUT1 zu erzeugen. Das Signaldiagramm in Figur 2 zeigt den Zusammenhang zwischen Eingangsund Ausgangssignal des Komparators 2. Mit ansteigender Eingangsspannung IN1 schaltet das Ausgangssignal OUT1 an der Schaltschwelle VS' von einem L-Pegel zu einem H-Pegel um. Wenn das Eingangssignal IN1 anschließend absinkt, erfolgt das Umschalten des Ausgangssignal OUT1 bei der niedrigeren Schwelle VS. Zwischen den Schaltschwellen VS, VS' liegt eine Hysterese vor, indem die Schaltschwellen um die Spannung VH voneinander verschieden sind.

Der Komparator 2 basiert auf einem Differenzverstärker, welcher zwei sourcegekoppelte n-Kanal-MOS-Transistoren M21, M22 enthält, die über eine aus einem Transistor M25 gebildete Stromquelle mit dem Bezugspotentialanschluß der Versorgungsspannungsquelle verbunden sind. Bezugspotential ist Masse VSS. An den Gateanschluß des Transistors M21 ist eine (zweite) auf Masse bezogene Referenzspannung VS angelegt, die der unteren Schaltschwelle VS in Figur 2 entspricht. An den Gateanschluß des Transistors M22 ist das Eingangssignal IN1 anzulegen. Die Stromzweige des Differenzverstärkers sind auf Seite des positiven Versorgungspotentials VDD der Versorgungsspannung über einen Stromspiegel M23, M24 miteinander gekoppelt. Das Ausgangssignal OUT1 des Komparators 2 wird am Kopplungsknoten der Transistoren M22, M24 abgegriffen und über eine Treiberstufe M27, M28 ausgangsseitig bereitgestellt. P-Kanal-MOS-Transistoren sind mit einem vom Gate weg weisenden Pfeil gekennzeichnet, n-Kanal-MOS-Transistoren mit einem zum Gate hin weisenden Pfeil.

Die Last M24 im Ausgangszweig des Differenzverstärkers des Komparators 2 wird durch eine Parallelschaltung von Transistoren M241, M242 gebildet. In den Strompfad mit dem Transistor M242 ist ein Schalttransistor M26 geschaltet, der durch das Ausgangssignals OUT1 gesteuert wird. Der als p-Kanal-MOS-Transistor ausgeführte Schalter M26 ist bei einem H-Pegel des Ausgangssignals OUT1 gesperrt, bei einem L-Pegel leitend geschaltet. Die Last M24 wird daher im ersteren Schaltzustand nur durch den Transistor M241 gebildet, im letzteren Schaltzustand durch die Parallelschaltung der Transistoren M241, M242. Durch diesen unsymmetrischen Aufbau des Differenzverstärkers des Komparators 2 wird sein Offset durch das Ausgangssignal OUT1 schaltbar gesteuert. Bekanntlich ist die Offsetspannung eines Komparators diejenige Spannung, die eingangsseitig anzulegen ist, damit das Ausgangssignal schwebend im Gleichgewicht ist, d.h. bei der Schaltschwelle liegt. Im Signaldiagramm ist der Offset die Verschiebung der Schaltschwelle gegenüber dem Nullpunkt der Differenzspannung an den Eingängen des Komparators. Durch den Offset wird daher die Schaltschwelle des Komparators festgelegt. Für Pegelübergänge des Eingangssignals IN1 von H nach L ist für die Last M24 nur der Transistor M241 wirksam, so daß die Schaltschwelle beim niedrigeren Wert VS liegt. Für Übergänge des Eingangssignals IN1 von L nach H ist für die Last M24 die Parallelschaltung der Transistoren M241, M242 wirksam, so daß die Schaltschwelle beim höheren Wert VS' liegt. Im ersteren Fall ist der Offset des Komparators nahezu Null, im Idealfall, wenn M3 und M41 gleich dimensioniert sind, genau Null, so daß die Schaltschwelle nur durch das Referenzsignal VS festgelegt wird. Im letzteren Fall wird der Offset des Komparators 2 durch die unsymmetrische Ausbildung seiner Differenzverstärkerlasten auf den Wert VH eingestellt, so daß die Schaltschwelle bei der Spannung VS + VH liegt. Durch die ausgangssignalabhängige Umschaltung der Komparatorschwelle ergibt sich die gewünschte Hysterese VH.

Um die untere Schaltschwelle VS und die Hysterese VH in absoluter Höhe vorzugeben, ist eine Regelschaltung 1 vorgesehen, die ein Steuersignal VB erzeugt. Das Steuersignal VB wird dem Gateanschluß des Stromquellentransistors M25 zugeführt, um dessen Stromstärke einzustellen. Außerdem wird durch das Signal VB der bezugspotentialseitige Stromquellentransistor M28 im Ausgangstreiberstrompfad der Schaltstufe 2 gesteuert.

Die Regelschaltung enthält einen Differenzverstärker mit sourcegekoppelten Transistoren M11, M12. Zwischen die die Eingangsanschlüsse des Differenzverstärkers bildenden Gateanschlüsse der Transistoren M11, M12 ist die (erste) Referenzspannung VH angelegt, durch die die Hysterese bestimmt wird. Der Gateanschluß des Transistors M11 ist darüber hinaus durch die auf Bezugspotential bezogene (zweite) Referenzspannung VS, die die untere Schaltschwelle des Komparators 2 festlegt, vorgespannt. Auf Seite des Versorgungspotentials VDD ist in den den Transistor M12 enthaltenden Differenzverstärkerzweig als Last M14 eine Parallelschaltung aus Transistoren M141, M142 geschaltet, die gleich angesteuert werden, indem deren Gateanschlüsse miteinander verbunden sind. Im anderen, den Transistor M11 enthaltenden Differenzverstärkerzweig liegt eine durch einen Transistor M13 gebildete Last. Die Lasten M13, M14 sind unterschiedlich, so daß der Differenzverstärker der Regelschaltung 1 unsymmetrisch ist. Der Differenzverstärker weist daher einen Offset auf. Der Offset ist in seiner absoluten Höhe durch Veränderung des Stroms IB einstellbar, der am Kopplungsknoten der Sourceanschlüsse der Transistoren M11, M12 eingeprägt wird. Hierzu dient eine durch einen Transistor M15 gebildete, nach Bezugspotential geschaltete Stromquelle. Durch eine Regelschleife mit invertierender Rückkopplung wird der Strom IB derart eingestellt, daß der Offset des Differenzverstärkers auf dessen Eingangsreferenzspannung VH ausgeregelt wird. Dies bedeutet, daß die Differenz aus Offset und Referenzspannung VH möglichst klein wird; abgesehen von einem proportionalen Regelfehler, der in der Praxis vernachlässigbar ist, stellt sich der tatsächliche Offset der Verstärkerstufe gleich der Vorgabe durch das Referenzsignal VH ein.

Die Regelschleife enthält im einzelnen einen (ersten) Strompfad aus Transistor M17, M19, wobei der Transistor M17 mit dem Lasttransistor M13 des Differenzverstärkers einen Stromspiegel bildet. Ein auf Seite des Versorgungspotentials VDD geschalteter Transistor M16 wird gleich der anderen Last M14 des Differenzverstärkers gesteuert, indem deren Gateanschlüsse miteinander verbunden sind. Der Transistor M16 ist in einem (zweiten) Strompfad enthalten. Dieser wird über einen bezugspotentialseitigen Stromspiegel M18, M19 in den ersten Strompfad eingekoppelt. Am Kopplungsknoten der Transistoren M17, M19 des ersten Strompfads wird ein Korrekturstrom IK abgegriffen, der im Vergleich zur dargestellten Stromrichtung während der Regelung positiv oder negativ gerichtet sein kann. Der Stromquellentransistor 15 des Differenzverstärkers schließlich wird über einen Stromspiegel M15, M110 angesteuert. Der Transistor M110 ist in einem (weiteren) Strompfad enthalten, der einen durch eine Stromquelle gebildeten Referenzstrom IR führt. In diesen Strompfad wird der Korrekturstrom IK eingekoppelt. Diese Regelschleife bewirkt, daß sich der durch die unsymmetrische Dimensionierung der Lastelemente des Differenzverstärkers gebildete Offset gleich der Vorgabe durch die Referenzspannung VH einstellt.

Die den Stromquellentransistor M15 steuernde Steuerspannung VB dient als Ausgangssignal der Regelschaltung 1. Die Steuerspannung VB wird zur Steuerung eines entsprechenden Stromquellentransistors im Komparator 2 verwendet, so daß dessen Offsetspannung abhängig von der sich in der Regelschaltung 1 einstellenden Offsetspannung bestimmt wird. Wenn die Last M24 des Komparators 2 durch die Parallelschaltung der Transistoren M241, M242 gebildet wird und unter der Voraussetzung, daß einander entsprechende Elemente der Differenzverstärker der Regelschaltung 1 und des Komparators 2 relativ zueinander gleich dimensioniert sind, weisen die Differenzverstärker beider Schaltungsteile 1, 2 den gleichen Offset auf. Der Offset des Komparators 2 und somit dessen Hysterese sind daher durch die Regelschaltung 1 auf den gewünschten Wert VH unabhängig von etwaigen Herstellungs- oder temperaturbedingten Schwankungen einstellbar.

Dem Komparator 2 sind weitere Komparatoren bezüglich der Referenzspannung VS sowie der Steuerspannung VB parallel schaltbar, von denen ein Komparator 3 beispielhaft dargestellt ist. Sofern die Transistoren der weiteren Komparatoren 3 gleich den Transistoren M21, M22, M23, M24, M25 des Differenzverstärkers des Komparators 2 dimensioniert sind, ergibt sich auch dort der gleiche Offset, der exakt der Vorgabe durch das Referenzsignal VH entspricht. Da die Regelschaltung 1 nur einmal erforderlich ist, sind eine Vielzahl gleichartiger Komparatoren mit gleichen, genau definierten Schaltpunkten bei geringem Aufwand und Flächenverbrauch realisierbar.

Die Referenzspannungen VH, VS werden zweckmäßigerweise mittels eines Spannungsteilers R1, R2, R3 erzeugt. Der Spannungsteiler ist zwischen die Versorgungsspannung VDD, VSS geschaltet und weist einen Widerstand R2 auf, der zwischen die Gateanschlüsse der Transistoren M11, M12 geschaltet ist. Bezugspotentialseitig ist der Widerstand R2 über einen weiteren Widerstand R3 angeschlossen; versorgungspotentialseitig ist er über einen Widerstand R1 an den Anschluß für das Versorgungspotential VDD gekoppelt. Die Referenzspannung VS fällt an der Reihenschaltung der Widerstände R2, R3 ab. Da bei integrierter Realisierung das relative Verhältnis der Widerstände R1, R2, R3 zueinander weitgehend exakt einstellbar ist, werden die Referenzsignale VS, VH exakt vorgegeben.

## Patentansprüche

1. Komparatoranordnung mit Schalthysterese umfassend:
- eine Regelschaltung (1) zur Erzeugung eines Steuersignals (VB), die
- einen Differenzverstärker (M11, ..., M15) enthält, mit einer Differenzverstärkerstufe (M11, M12), zwei Lastelementen (M13, M14) und einer gemeinsamen Stromquelle (M15) zum kontinuierlichen Steuern des Offsets,
- zwischen dessen Eingangssignalanschlüssen Mittel (R2) zur Erzeugung eines ersten Referenzsignals (VH), das ein Maß für die durch die Hysterese gebildete Verschiebung von Schaltschwellen der Komparatoranordnung ist, geschaltet sind,
- dessen einer Eingangssignalanschluß gegenüber einem Bezugspotentialanschluß (VSS) mit einem Mittel (R2, R3) zur Erzeugung eines zweiten Referenzsignals (VS), das ein Maß für eine der Schaltschwellen der Komparatoranordnung ist, verbunden ist, und
- in dem das Steuersignal (VB) auf den Steuereingang der Stromquelle (M15) rückgekoppelt wird, um den Offset zu steuern, so daß der Offset auf das erste Referenzsignal (VH) ausgeregelt wird, und
- einen Komparator (2),
- der einen Offset aufweist, der abhängig von einem Ausgangssignal (OUT1) des Komparators (2) schaltbar gesteuert wird und vom Steuersignal (VB) kontinuierlich gesteuert wird,
- der einen Eingangsanschluß aufweist, der an die Mittel (R2, R3) zur Erzeugung des zweiten Referenzsignals (VS) angeschlossen ist, und
- der einen weiteren Eingangsanschluß für ein Eingangssignal (IN1) aufweist.

2. Komparatoranordnung nach Anspruch 1,
**dadurch gekennzeichnet, daß**
der Komparator (2) und die Regelschaltung (1) jeweils einen Differenzverstärker (M11, ..., M15; M21, ..., M25) mit einer auf der Seite des Bezugspotentialanschlusses (VSS) angeordneter Stromquelle (M15; M25) umfassen, deren Stromstärke vom Steuersignal (VB) gesteuert wird.

3. Komparatoranordnung nach Anspruch 2,
**dadurch gekennzeichnet, daß**
einer der Zweige (M11, M13) des Differenzverstärkers der Regelschaltung (1) versorgungspotentialseitig einen Stromspiegel (M13, M17) mit einem ersten Strompfad (M17, M19) bildet, **daß** ein Lastelement (M14) des anderen der Zweige (M12, M14) des Differenzverstärkers der Regelschaltung (1) gleich einem versorgungspotentialseitigen Lastelement (M16) in einem zweiten Strompfad (M16, M18) gesteuert wird, und **daß** der zweite Strompfad (M16, M18) einen bezugspotentialseitigen Stromspiegel (M18, M19) mit dem ersten Strompfad (M17, M19) bildet.

4. Komparatoranordnung nach Anspruch 3,
**dadurch gekennzeichnet, daß**
die auf der Seite des Bezugspotentialanschlusses (VSS) angeordnete Stromquelle (M15) des Differenzverstärkers der Regelschaltung (1) mit einem weiteren Strompfad (M110, IR) einen Stromspiegel (M15, M110) bildet, und **daß** in diesen Stromspiegel ein Korrekturstrom (IK) eingekoppelt wird, der vom ersten Strompfad (M17, M19) abgegriffen wird.

5. Komparatoranordnung nach einem der Ansprüche 2 bis 4,
**dadurch gekennzeichnet, daß**
die Lastzweige (M21, M23; M24, M22) des Differenzverstärkers des Komparators (2) versorgungspotentialseitig über einen Stromspiegel (M23, M24) gekoppelt sind, daß dieser Stromspiegel ausgangsseitig ein erstes Lastelement (M241) enthält, dem mittels Steuerung durch das Ausgangssignal (OUT1) des Komparators (2) ein weiteres Lastelement (M242) zuschaltbar ist, und daß die Steueranschlüsse der Lastelemente (M241, M242) gekoppelt sind.

6. Komparatoranordnung nach einem der Ansprüche 2 bis 4,
**dadurch gekennzeichnet, daß**
der andere Zweig (M12, M14) des Differenzverstärkers der Regelschaltung (1) als Lastelement die Parallelschaltung zweier Transistoren (M141, M142) mit gekoppelten Steueranschlüssen enthält.

7. Komparatoranordnung nach Ansprüche 5 oder 6,
**dadurch gekennzeichnet, daß**
die Lastelemente der Differenzverstärker des Komparators (2) und der Regelschaltung (1) Transistoren (M23, M241, M242; M12, M141, M142) sind, die vom gleichem Typ und gleicher Größe sind.

8. Komparatoranordnung nach einem der Ansprüche 1 bis 7,
**gekennzeichnet durch**
weitere gleichartige Komparatoren (3), die bezüglich des Steuersignals (VB) und des zweiten Referenzsignals (VS) parallel zum einen Komparator (2) geschaltet sind.

9. Komparatoranordnung nach einem der Ansprüche 1 bis 8,
**dadurch gekennzeichnet, daß**
die Mittel zur Erzeugung der Referenzsignale (VS, VH) durch einen zwischen Anschlüsse für die Versorgungsspannung (VSS, VDD) geschalteten Spannungsteiler (R1, R2, R3) gebildet sind.

## Claims

1. A comparator arrangement with switching hysteresis, comprising:
- a control circuit (1) for generating a control signal (VB), which
- contains a difference amplifier (M11, ..., M15), having a difference amplifier stage (M11, M12), two load elements (M13, M14) and a common current source (M15) for continuous control of the offset,
- between the input signal terminals of which there are connected means (R2) for generating a first reference signal (VH), which is a measure of the shift, formed by the hysteresis, of switch points of the comparator arrangement,
- the one input signal terminal of which is connected opposite a reference potential terminal (VSS) with a means (R2, R3) for generating a second reference signal (VS), which is a measure of one of the switch points of the comparator arrangement, and
- in which the control signal (VB) is fed back to the control input of the current source (M15), in order to control the offset, such that the offset is adjusted to the first reference signal (VH), and
- a comparator (2),
- which comprises an offset, which is controlled in switchable manner as a function of an output signal (OUT1) of the comparator (2) and is controlled continuously by the control signal (VB),
- which comprises an input terminal, which is connected to the means (R2, R3) for generating the second reference signal (VS), and
- which comprises a further input terminal for an input signal (IN1).

2. A comparator arrangement according to claim 1,
**characterised in that**
the comparator (2) and the control circuit (1) each comprise a difference amplifier (M11, ..., M15; M21, ..., M25) with a current source (M15; M25) arranged on the side of the reference potential terminal (VSS), the current intensity of which current source (M15; M25) is controlled by the control signal (VB).

3. A comparator arrangement according to claim 2,
**characterised in that**
one of the branches (M11, M13) of the difference amplifier of the control circuit (1) forms on the supply potential side a current mirror (M13, M17) with a first current path (M17, M19), **in that** a load element (M14) of the other of the branches (M12, M14) of the difference amplifier of the control circuit (1) is controlled like a supply potential-side load element (M16) in a second current path (M16, M18), and **in that** the second current path (M16, M18) forms a reference potential-side current mirror (M18, M19) with the first current path (M17, M19).

4. A comparator arrangement according to claim 3,
**characterised in that**
the current source (M15) of the difference amplifier of the control circuit (1), which current source (M15) is arranged on the side of the reference potential terminal (VSS), forms a current mirror (M15, M110) with a further current path (M110, IR), and **in that** a correction current (IK) is coupled into this current mirror, which correction current (IK) is tapped from the first current path (M17, M19).

5. A comparator arrangement according to one of claims 2 to 4,
**characterised in that**
the load branches (M21, M23; M24, M22) of the difference amplifier of the comparator (2) are coupled on the supply potential side via a current mirror (M23, M24), **in that** this current mirror includes a first load element (M241) on the output side, to which first load element (M241) a further load element (M242) may be connected by means of control by the output signal (OUT1) of the comparator (2), and **in that** the control terminals of the load elements (M241, M242) are coupled.

6. A comparator arrangement according to one of claims 2 to 4,
**characterised in that**
the other branch (M12, M14) of the difference amplifier of the control circuit (1) contains as load element the parallel circuit of two transistors (M141, M142) with coupled control terminals.

7. A comparator arrangement according to claims 5 or 6,
**characterised in that**
the load elements of the difference amplifiers of the comparator (2) and the control circuit (1) are transistors (M23, M241, M242; M12, M141, M142), which are of the same type and same size.

8. A comparator arrangement according to one of claims 1 to 7,
**characterised by**
further similar comparators (3), which are connected in parallel with the one comparator (2) with regard to the control signal (VB) and the second reference signal (VS).

9. A comparator arrangement according to one of claims 1 to 8,
**characterised in that**
the means for generating the reference signals (VS, VH) take the form of a voltage divider (R1, R2, R3) connected between terminals for the supply voltage (VSS, VDD).

## Revendications

1. Comparateur à hystérésis comprenant :
- un circuit de régulation (1) générant un signal de commande (VB) et ayant
* un amplificateur de différence (M11, ..., M15) avec un étage d'amplificateurs de différence (M11, M12), deux éléments de charge (M13, M14) et une source de courant commune (M15) pour commander le décalage en continu,
* entre les bornes d'entrée de signal, un moyen (R2) pour générer un premier signal de référence (VH) qui est une mesure du décalage des seuils de commutation du comparateur résultant de l'hystérésis,
* dont la borne d'entrée de signal est reliée par rapport à une borne de potentiel de référence (VSS) à un moyen (R2, R3) pour générer un second signal de référence (VS) qui est une mesure de l'un des seuils de commutation du comparateur et
* dans lequel le signal de commande (VB) est couplé en réaction sur l'entrée de commande de la source de courant (M15) pour en commander le décalage de façon à réguler le décalage suivant le premier signal de référence (VH) et
- un comparateur (2),
* ayant un décalage commandé en fonction du signal de sortie (OUT1) du comparateur (2), de manière commutée et de façon commandée à partir du signal de commande (VB).
* une première entrée reliée aux moyens (R2, R3) générant le second signal de référence (VS) et
* ayant une autre entrée pour un signal d'entrée (IN1).

2. Comparateur selon la revendication 1,
**caractérisé en ce que**
le comparateur (2) et le circuit de régulation (1) comportent chacun un amplificateur de différence (M11, ..., M15 ; M21..., M25) avec une source de courant (M15; M25) prévue sur le côté de la borne de potentiel de référence (VSS), l'intensité du courant de ces sources étant commandée par le signal de commande (VB).

3. Comparateur selon la revendication 2,
**caractérisé en ce que**
l'une des branches (M11, M13) de l'amplificateur de différence du circuit de régulation (1) comporte, du côté du potentiel de référence, un miroir de courant (M13, M14) avec un premier chemin de courant (M17, M19), un élément de charge (M14) de l'autre branche (M12, M14) de l'amplificateur de différence du circuit de régulation (1) étant commandé égal à un élément de charge (M16) du côté du potentiel de référence dans un second chemin de courant (M16, M18) et
le second chemin de courant (M16, M18) forme un miroir de courant (M18, M19) du côté du potentiel de référence avec le premier chemin de courant (M17, M19).

4. Comparateur selon la revendication 3,
**caractérisé en ce que**
la source de courant (M15) de l'amplificateurs de différence du circuit de régulation (1), du côté de la borne de potentiel de référence (VSS), forme un miroir de courant (M15, M110) avec un autre chemin de courant (M110, IR) et
un courant de correction (IK) est couplé dans ce miroir de courant, ce courant de correction étant pris dans le premier chemin de courant (M17, M19).

5. Comparateur selon l'une quelconque des revendications 2 à 4,
**caractérisé en ce que**
les branches de charge (M21, M23; M24, M22) de l'amplificateur de différence du comparateur (2) sont couplées du côté du potentiel d'alimentation par un miroir de courant (M23, M24),
ce miroir de courant comportant en sortie un premier élément de charge (M241), sur lequel on branche un autre élément de charge (M242) en commandant le signal de sortie (OUT1) du comparateur (2), et les bornes de commande de l'élément de charge (M241, M242) sont couplées.

6. Comparateur selon l'une quelconque des revendications 2 à 4,
**caractérisé en ce que**
l'autre branche (M12, M14) de l'amplificateur de différence du circuit de régulation (1) comporte, comme élément de charge, le montage en parallèle de deux transistors (M141, M142) dont les bornes de commande sont couplées.

7. Comparateur selon l'une quelconque des revendications 5 ou 6,
**caractérisé en ce que**
les éléments de charge des amplificateurs de différence du comparateur (2) et du circuit de régulation (1) sont des transistors (M23, M241, M242; M12, M141, M142) de même type et de même dimension.

8. Comparateur selon l'une quelconque des revendications 1 à 7,
**caractérisé par**
d'autres comparateurs (3) de même type branchés en parallèle à un comparateur (2) pour le signal de commande (VB) et le second signal de référence (VS).

9. Comparateur selon l'une quelconque des revendications 1 à 8,
**caractérisé en ce que**
les moyens pour générer les signaux de référence (VS, VH) sont formés par un diviseur de tension (R1, R2, R3) branché entre les bornes de la tension d'alimentation (VSS, VDD).
